# EUROPÄISCHE PATENTANMELDUNG

(11) **EP 4 852 236 A1**
(43) Veröffentlichungstag der Anmeldung: **09.12.2026**
(21) Anmeldenummer: 26165396.8
(22) Anmeldetag: 17.03.2026
(51) Int. Cl.: H01R 43/28, G01R 31/58, H01R 9/05, H01R 103/00

(54) **VORRICHTUNG UND VERFAHREN ZUM ERFASSEN, INSBESONDERE AUCH ZUM EINSTELLEN, EINES RÜCKSTANDSMASSES BEI EINEM TEILKONFEKTIONIERTEN KABEL**

(30) Priorität: 06.06.2025 DE 102025122352
(71) Anmelder: MD ELEKTRONIK GmbH, 84478 Waldkraiburg (DE)
(72) Erfinder: Jakob, Sebastian, 83134 Prutting (DE); Riegl, Christoph, 84437 Reichertsheim (DE); Eberl, Tobias, 83567 Unterreit (DE); Sonnenhuber, Thomas, 83123 Amerang (DE)

(57) **Zusammenfassung**

Die vorliegende Erfindung betrifft eine Vorrichtung (1) zum Erfassen des Rückstandsmaßes bei einem teilkonfektionierten Kabel (2), wobei das teilkonfektionierte Kabel (2) einen Außenleiter-Kontakt (3), einen innerhalb des Außenleiter-Kontakts (3) aufgenommenen, innerhalb eines Isolators (4) angeordneten, Innenleiter-Kontakt (5) aufweist ist, wobei die Vorrichtung (1) umfasst:
eine Messhülse (6) mit einem Gehäuse (7), einer in dem Gehäuse (7) in einer Längsrichtung (L) verschieblich geführten Messnadel (8) und einem Messtaster (9), wobei der Messtaster (9) die Verschiebung der Messnadel (8) in Bezug auf das Gehäuse (7) erfasst und wobei das Gehäuse (7) eine Referenzebene (R) aufweist,
eine Halteeinheit (10), die ausgebildet ist, den Außenleiter-Kontakt (3) des teilkonfektionierten Kabels (2) ortsfest zu halten,
einen ersten Antrieb, der ausgebildet ist, die Messhülse (6) in der Längsrichtung (L) in Bezug auf das Kabel (2) so zu verschieben, dass die Messnadel (8) in den Innenleiter-Kontakt (5) des Kabels (2) eindringt,
wobei die Halteeinheit (10) ausgebildet ist, das Außenleiter-Kontaktteil (3) zentriert zu der Längsrichtung (L) ausgerichtet zu halten, und
eine Steuereinheit, die den ersten Antrieb und die Halteeinheit (10) ansteuert.

Die Vorrichtung (1) ist insbesondere auch zur Einstellung eines Rückstandsmaßes ausgebildet, wobei die Steuereinheit ausgebildet ist, den ersten Antrieb so lange anzusteuern, bis das erfasste Rückstandsmaß einem vorgegebenen Soll-Wert entspricht. Die Erfindung betrifft weiter ein Verfahren zum Erfassen, insbesondere zum Einstellen, eines Rückstandsmaßes bei einem teilkonfektionierten Kabel.

## Beschreibung

### Technisches Gebiet

Die Erfindung betrifft eine Vorrichtung sowie ein bevorzugt unter Verwendung der Vorrichtung durchführbares Verfahren zum Erfassen, insbesondere auch zum Einstellen, eines Rückstandsmaßes bei einem teilkonfektionierten Kabel.

### Stand der Technik

Aus der Praxis der Konfektionierung eines Datenkabels, das einen Innenleiter, ein den Innenleiter umgebendes Dielektrikum und einen das Dielektrikum umgebenden Außenleiter innerhalb des Kabelmantels umfasst, ist es bekannt, den Kabelmantel an einem Ende zu entfernen und an den freigelegten Außenleiter einen Außenleiter-Kontakt anzubringen. Im weiteren Verlauf der Konfektionierung wird an den abschnittsweise freigelegten Innenleiter ein Innenleiter-Kontakt angebracht. Der Innenleiter-Kontakt wird, innerhalb eines Isolators fest aufgenommen, innerhalb des Außenleiter-Kontakts angeordnet.

Für Datenkabel sind insbesondere sogenannte Buchs-Kontakte bekannt, bei denen der Innenleiter Innenleiter-Kontaktzungen aufweist, die mit stiftförmigen Innenleiter-Kontakten eines Gegensteckers zusammenwirken. Dabei dringt der stiftförmige Innenleiter-Kontakt des Gegensteckers in den Bereich zwischen den Innenleiter-Kontaktzungen des Buchs-Kontakts ein, um die beiden Innenleiter der beiden Kabel mechanisch und elektrisch zu verbinden.

Für die weitere Bearbeitung eines nur teilweise konfektionierten Kabels ist es erforderlich, einen Abstand von den Kontaktzungen des Innenleiter-Kontaktes zu der vorderen Kante des Außenleiters zu kennen, da dieser Abstand ein Maß dafür ist, ob und, wenn ja, inwieweit ein stiftförmiger Innenleiter-Kontakt eines Gegensteckers in den fertig konfektionierten Stecker des teilkonfektionierten Kabels eindringen kann. Ein derartiger Abstand wird insbesondere über ein Rückstandsmaß definiert bzw. ermittelt.

Ist das bei dem teilkonfektionierten Kabel ermittelte Rückstandsmaß ausreichend, also innerhalb eines fest vorgegebenen Wertebereichs in Bezug auf einen vorgegebenen Soll-Wert für das Rückstandsmaß, kann das teilkonfektionierte Kabel weiter bearbeitet werden. Weicht das ermittelte Rückstandsmaß von dem vorgegebenen Soll-Wert für das Rückstandsmaß deutlich ab, muss das teilkonfektionierte Kabel von der weiteren Bearbeitung, insbesondere der Fertigstellung des Konfektionsprozesses, ausgeschlossen werden.

Für die manuelle Ermittlung des Rückstandsmaßes bei einem teilkonfektionierten Kabel ist es aus der Praxis bekannt, eine Messhülse vorzusehen, wobei die Messhülse eine in einem Gehäuse längsverschieblich aufgenommene Messnadel aufweist, wobei die Messnadel zwischen die Kontakt-Zungen des Innenleiter-Kontakts eingeführt werden kann. Die Messnadel wird bei dem Eindringen in den Bereich zwischen die Innenleiter-Kontaktzungen in Bezug auf das Gehäuse der Messhülse verschoben, wobei die Verschiebung der Messnadel von einem Messtaster erfasst wird. Für die manuelle Ermittlung des Rückstandsmaßes bei Verwendung einer aus dem Stand der Technik bekannten Messhülse ist insbesondere zu beachten, dass die Längsrichtung, entlang derer die Messnadel relativ zu dem Gehäuse der Messhülse verschoben wird, exakt zu der Längsrichtung ausgerichtet ist, die durch die Kontaktzungen des Innenleiter-Kontakts bzw. des den Innenleiter-Kontakts aufnehmenden Isolators des zu prüfenden teilkonfektionierten Kabels ausgerichtet ist. Liegt der manuell ermittelte Betrag des Rückstandsmaßes außerhalb eines zulässigen, vorgegebenen Wertebereichs in Bezug auf einen vorgegebenen Soll-Wert, muss das manuell geprüfte teilkonfektionierte Kabel von der weiteren Bearbeitung ausgenommen werden und wird als Ausschuss angesehen.

DE 10 2018 127 969 A1 beschreibt eine Vorrichtung sowie ein Verfahren zur Messung eines Abstands zwischen dem freien Ende eines Innenleiterkontakts und einer vorderen Kante einer Stützhülse bzw. einem Schirmgeflecht, das die durch das Abmanteln gebildete Kante überdeckt. Dazu wird die vorderen Kante der Stützhülse bzw. die durch das Abmanteln gebildete, von dem Schirmgeflecht überdeckte Kante an einen Referenzanschlag einer Referenzeinrichtung in Anlage gebracht und der Abstand zu dem freien Ende des Innenleiterkontaktteils ermittelt, beispielsweise mittels eines Messtasters, eines induktiven, kapazitiven oder optischen Sensors. Der gemessene Abstand zwischen dem freien Ende des Innenleiterkontakts und der an dem Referenzanschlag anliegenden Kante der Stützhülse, als Anschlussabstand bezeichnet, ist eine andere Messgröße als das oben definierte Rückstandsmaß, nämlich der Abstand der vorderen Kante der Kontaktzungen zu der vorderen Kante des Außenleiters. Mit der in der DE 10 2018 127 969 A1 beschriebenen Vorrichtung lässt sich das Rückstandsmaß nicht messen; ebenso lässt sich mit dem in der DE 10 2018 127 969 A1 beschriebenen Verfahren das Rückstandsmaß nicht ermitteln. Zu beachten ist auch, dass der Anschlussabstand sowie das Rückstandsmaß nach verschiedenen Bearbeitungsschritten während des Konfektionsprozesses ermittelt werden.

### Beschreibung der Erfindung

Es ist eine Aufgabe der Erfindung, eine möglichst automatisierte Erfassung des Rückstandsmaßes bei einem teilkonfektionierten Kabel so zu ermöglichen, dass der Ausschuss an Kabeln reduziert wird.

Diese Aufgabe wird erfindungsgemäß gelöst durch eine Vorrichtung zum Erfassen des Rückstandsmaßes bei einem teilkonfektionierten Kabel, wobei das teilkonfektionierte Kabel einen Außenleiter-Kontakt, einen innerhalb des Außenleiter-Kontakts aufgenommenen, innerhalb eines Isolators angeordneten Innenleiter-Kontakt aufweist ist, wobei die Vorrichtung erfindungsgemäß umfasst:
- eine Messhülse mit einem Gehäuse, einer in dem Gehäuse in einer Längsrichtung verschieblich geführten Messnadel und einem Messtaster, wobei der Messtaster die Verschiebung der Messnadel in Bezug auf das Gehäuse erfasst, und wobei das Gehäuse eine Referenzebene aufweist,
- eine Halteeinheit, die ausgebildet ist, den Außenleiter-Kontakt des teilkonfektionierten Kabels ortsfest zu halten,
   - - einen ersten Antrieb, der ausgebildet ist, die Messhülse in der Längsrichtung in Bezug auf das Kabel so zu verschieben, dass die Messnadel in den Innenleiter-Kontakt des Kabels eindringt,
- wobei die Halteeinheit ausgebildet ist, das Außenleiter-Kontaktteil zentriert zu der Längsrichtung ausgerichtet zu halten, und
- eine Steuereinheit, die den ersten Antrieb und die Halteeinheit ansteuert.

Die Steuereinheit ist ausgelegt, die Halteeinheit so anzusteuern, dass die Halteeinheit das Außenleiter-Kontaktteil zentriert zu der Längsrichtung ausgerichtet hält, entlang derer die Messnadel in der Messhülse verschoben wird, wenn der von der Steuereinheit angesteuerte erste Antrieb die Messhülse in Richtung des zu prüfenden Kabels bewegt. Das Gehäuse der Messhülse bildet dabei abschnittsweise eine Referenzebene, auf die bezogen, aus der Verschiebung der Messnadel, das Rückstandsmaß ermittelt, insbesondere einfach abgelesen, werden kann.

Der von der Steuereinheit angesteuerte erste Antrieb kann dabei insbesondere einen Linearmotor umfassen, dessen Abgang parallel versetzt zu der Längsrichtung gerichtet ist, die durch die in dem Gehäuse der Messhülse verschieblich geführte Messnadel definiert ist.

Als Messhülse kann eine aus dem Stand der Technik bekannte Messhülse Verwendung finden, die, von dem angesteuerten ersten Antrieb definiert bewegt und verschoben, in der Längsrichtung ausgerichtet auf das in der Halteeinheit ortsfest aufgenommene Außenleiter-Kontaktteil hin bewegt wird.

Vorzugsweise ist vorgesehen, dass die Halteeinheit zwei Greiferbacken einer Greifereinheit umfasst, wobei die Greiferbacken den Außenleiter-Kontakt seitlich einspannen.

Die Steuereinheit der Vorrichtung ist insbesondere ausgelegt, die Halteeinheit so anzusteuern, dass während des Messens, also während des Eindringens der Messnadel in den Innenleiter-Kontakt des teilkonfektionierten Kabels, der Außenleiter-Kontakt fest gegriffen ortsfest gehalten ist. Der durch die Halteeinheit ortsfest gehaltene Außenleiter-Kontakt dient dabei als Widerlager, das die beim Anlegen der Messhülse an den Isolator ausgeübten Kräfte in der Längsrichtung aufnimmt. Insbesondere kann die Halteeinheit so ausgebildet sein, dass der Isolator mit dem Innenleiter-Kontakt beim Anlegen der Messhülse relativ zu dem gehaltenen Außenleiter-Kontaktteil in Längsrichtung des teilkonfektionierten Kabels um einen geringen Betrag verschoben werden kann, so dass ein Rückstandsmaß, das anfangs als zu gering in Bezug auf einen vorgegebenen Soll-Wert ermittelt wurde, nachträglich vergrößert werden kann, derart, dass das Rückstandsmaß nach dem Verschieben des Isolators relativ zu dem gehaltenen Außenleiter-Kontakt dem vorgegebenen Soll-Wert entspricht.

Vorzugsweise ist vorgesehen, dass die Steuereinheit ausgebildet ist, den ersten Antrieb so lange anzusteuern, bis das erfasste Rückstandsmaß einem vorgegebenen Soll-Wert entspricht. Während der erste Antrieb angesteuert wird, wird der aktuelle Wert des Rückstandsmaßes erfasst und mit dem Soll-Wert für das Rückstandsmaß verglichen. Der erste Antrieb wird außer Bewegung gesetzt, wenn der aktuelle Wert für das Rückstandsmaß dem Soll-Wert für das Rückstandsmaß, innerhalb der vorgegebenen Toleranzgrenzen, entspricht.

Vorzugsweise ist vorgesehen, dass die Vorrichtung weiter eine Spanneinheit umfasst, wobei die Spanneinheit das Kabel in einem Abstand von dem Außenleiter-Kontakt lösbar einspannt. Die Spanneinheit weist insbesondere einen Leitungsspanner auf, mit dem das zu prüfende teilkonfektionierte Kabel zu der Vorrichtung für die Messung hingeführt und nach der Messung von der Vorrichtung fort bewegt werden kann.

In Hinblick auf die Spanneinheit ist vorzugsweise vorgesehen, dass die Vorrichtung weiter einen zweiten Antrieb für die Spanneinheit aufweist, wobei die zweite Spanneinheit einen Motor aufweist, wobei der Motor des zweiten Antriebs auf einer Längsführung lösbar festlegbar ist und wobei der Motor des zweiten Antriebs auf der Längsführung längsverschieblich in eine Verschiebe-Richtung angeordnet ist, derart, dass die Verschiebe-Richtung parallel versetzt zu der durch den Innenleiter-Kontakt und die Messnadel definierten Längsrichtung ausgerichtet ist. Die Steuereinheit der Vorrichtung ist dabei ausgebildet, die Festlegung des Motors des zweiten Antriebs an der Längsführung zu lösen, um Materialspannungen in dem Kabel, insbesondere einer Auslenkung des zwischen der Spanneinheit und der Messhülse gestreckt eingespannt gehaltenen Kabels von der geraden Ausrichtung in der Längsrichtung, abzubauen, dann, wenn die Messhülse mit einer Kraft gegen den Isolator des Kabels gedrückt wird.

Vorzugsweise ist für die Messhülse vorgesehen, dass das Gehäuse der Messhülse eine Anlagefläche aufweist, die ausgebildet ist, an einer Gegen-Anlagefläche des Isolators anzuliegen, wenn die Messnadel in den Innenleiter-Kontakt eindringt.

Vorzugsweise ist hinsichtlich der Anlagefläche und der Gegen-Anlagefläche vorgesehen, dass der Neigungswinkel der Anlagefläche und der Gegen-Anlagefläche, jeweils bezogen auf die Längsrichtung, im Wesentlichen gleich ist. Die Anlagefläche und die Gegen-Anlagefläche wirken dabei als konisches Führungsflächenpaar zusammen, so dass sich eine zentrierte Ausrichtung des Isolators mit dem Innenleiter-Kontakt zu der Messnadel der Messhülse ergibt.

Die Erfindung betrifft weiter ein Verfahren zum Erfassen, insbesondere zum Einstellen eines Rückstandsmaßes bei einem teilkonfektionierten Kabel, wobei das Verfahren erfindungsgemäß die Schritte aufweist:
S1: Bereitstellen des teilkonfektionierten Kabels, wobei das teilkonfektionierte Kabel einen Außenleiter-Kontakt, einen innerhalb des Außenleiter-Kontakts aufgenommenen, innerhalb eines Isolators angeordneten Innenleiter-Kontakt aufweist,
S2: Bereitstellen einer Messhülse mit einem Gehäuse mit einer in dem Gehäuse längsverschieblich geführten Messnadel und mit einem Messtaster, wobei der Messtaster die Verschiebung der Messnadel in Bezug auf das Gehäuse erfasst, und wobei das Gehäuse eine Referenzebene aufweist, derart, dass die Verschiebe-Richtung der Messnadel in einer Verlängerung einer durch den Isolator des Kabels definierten Längsrichtung liegt,
S3: In-Anlage-Bringen einer Anlagefläche des Gehäuses der Messhülse an eine Gegen-Anlagefläche an dem Isolator des Kabels und Erfassen einer Verschiebung der Messnadel relativ zu dem Gehäuse durch den Messtaster der Messhülse und Ermitteln des Rückstandsmaßes,
S4: Andrücken der Anlagefläche der Messhülse an die Gegen-Anlagefläche des Isolators, wenn das in Schritt S3 ermittelte Rückstandsmaß geringer ist als ein vorgegebener Soll-Wert, und Erfassen des Rückstandsmaßes,
S5: Durchführen des Schrittes S4 so lange, bis das ermittelte Rückstandsmaß dem vorgegebenen Soll-Wert entspricht, und
S6: Beseitigen von Materialspannungen in dem Kabel.

Die Verfahrensschritte S1 bis S3 betreffen dabei ein Verfahren zum automatisierten Erfassen des Rückstandsmaßes. Ergibt sich, dass das bei Schritt S3 ermittelte Rückstandsmaß von einem Soll-Wert des Rückstandsmaßes abweicht, wird durch die Schritte S4 bis S6 das aktuelle Rückstandsmaß an den vorgegebenen Soll-Wert für das Rückstandsmaß herangeführt. Die Verfahrensschritte S4 bis S6 betreffen dabei ein Verfahren zum Einstellen eines Rückstandsmaßes auf einen vorgegebenen Soll-Wert.

Das Verfahren ist vorzugsweise auf einer erfindungsgemäßen Vorrichtung zur Erfassung des Rückstandsmaßes bei einem teilkonfektionierten Kabel durchführbar.

Wird das Verfahren als Verfahren zum automatisierten Erfassen des Rückstandsmaßes durchgeführt, ist bei einer beispielhaften Durchführung nach Schritt S3 ein "Fixieren des Außenleiter-Kontakts derart, dass der Außenleiter-Kontakt fest an dem Kabel angeordnet ist" vorgesehen.

Wird das Verfahren als Verfahren zum automatisierten Erfassen des Rückstandsmaßes (Schritte S1 bis S3) mit einem nachfolgenden Einstellen des Rückstandsmaßes (Schritte S4 bis S6) durchgeführt, ist bei einer beispielhaften Durchführung des Verfahrens ergänzend ein "Fixieren des Außenleiter-Kontakts derart, dass der Außenleiter-Kontakt fest an dem Kabel angeordnet ist" (Schritt S7) vorgesehen.

Nach dem "Fixieren des Außenleiter-Kontakts derart, dass der Außenleiter-Kontakt fest an dem Kabel angeordnet ist" (Schritt S7) ist bei einer beispielhaften Durchführung des Verfahrens weiter ein Schritt "Abschließendes Erfassen des Rückstandsmaßes, auszuführen nach Schritt S7" (Schritt S8) vorgesehen.

Weitere Vorteile und Merkmale der Erfindung ergeben sich aus den abhängigen Ansprüchen sowie der nachfolgenden Beschreibung mindestens eines Ausführungsbeispiels der Erfindung.

Die Erfindung wird im Folgenden unter Bezugnahme auf die anliegenden Zeichnungen anhand eines bevorzugten Ausführungsbeispiels näher beschrieben und erläutert.
- Fig. 1: zeigt eine perspektivische Ansicht eines Ausführungsbeispiels einer erfindungsgemäßen Vorrichtung zur Erfassung eines Rückstandsmaßes eines teilkonfektionierten Kabels,
- Fig. 1a: zeigt einen vergrößerten Ausschnitt des Ausführungsbeispiels aus Fig. 1 aus einer abgewandelten Blickrichtung,
- Fig. 2: zeigt eine Draufsicht auf das Ausführungsbeispiel aus Fig. 1,
- Fig. 3: zeigt eine Schnittansicht auf das Ausführungsbeispiel aus Fig. 1 und 2, bei einer beispielhaften Durchführung des erfindungsgemäßen Verfahrens,
- Fig. 4: zeigt eine perspektivische Ansicht zu Fig. 3, und
- Fig. 5: zeigt einen schematischen Ablauf einer beispielhaften Durchführung des Verfahrens zur Erfassung, nämlich auch zum Einstellen eines Rückstandsmaßes bei einem teilkonfektionierten Kabel aus Fig. 3, 4 unter Verwendung der Vorrichtung nach Fig. 1 bis Fig. 4.

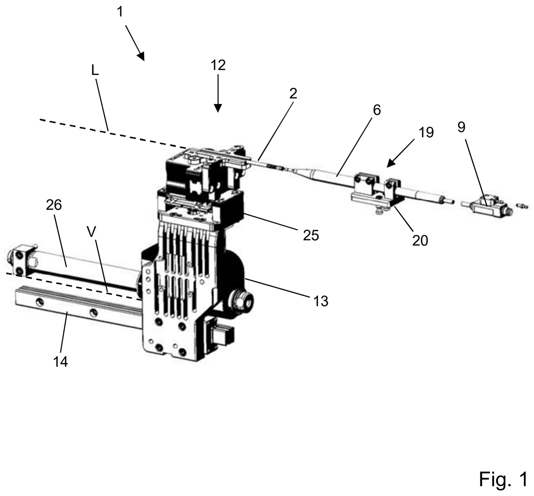

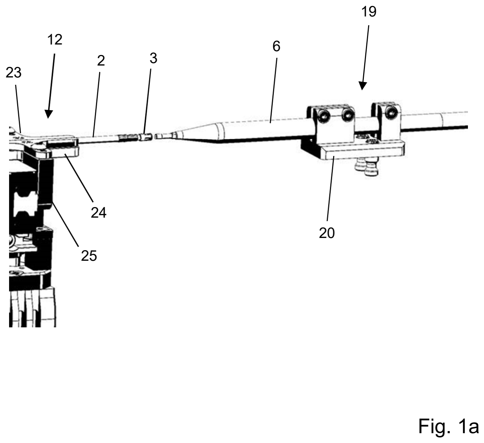

Fig. 1 zeigt eine perspektivische Ansicht eines Ausführungsbeispiels einer Vorrichtung 1 zur automatisierten Erfassung eines Rückstandsmaßes bei einem teilkonfektionierten Kabel 2.

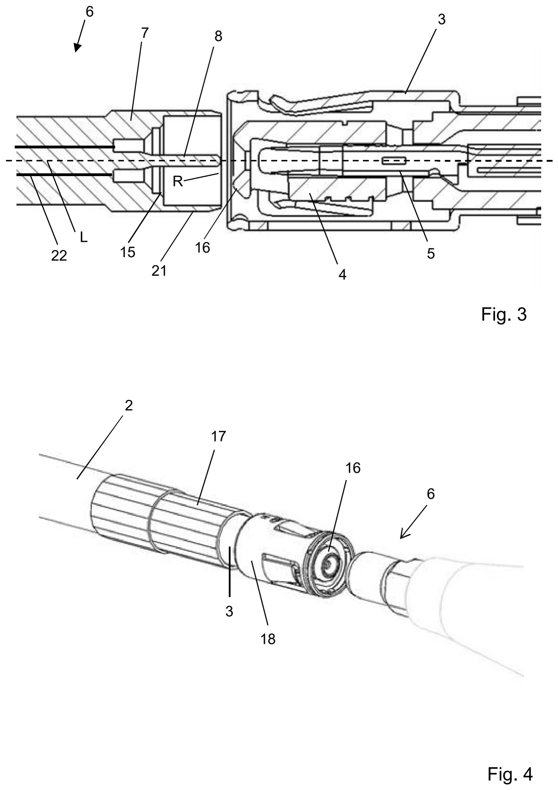

Der teilkonfektionierte Bearbeitungszustand des Kabels 2 ist dabei aus Fig. 4 in einer perspektivischen Ansicht und aus Fig. 3 in einer Längsschnittansicht ersichtlich.

Bei dem teilkonfektionierten Kabel 2 aus Fig. 3 und 4 war in einem vorbereitenden Bearbeitungsschritt der Kabelmantel endseitig entfernt worden, dann das Dielektrikum soweit entfernt, dass der Innenleiter freiliegt. An den freigelegten Innenleiter ist ein Innenleiter-Kontakt 5 befestigt, wobei der Innenleiter-Kontakt 5 in einem Isolator 4, ggf. auch in einem Kontaktträger, aufgenommen ist. Der Innenleiter-Kontakt 5 ist in dem Isolator 4 fest ausgenommen, insbesondere verrastet festgelegt. Der Isolator 4 ist innerhalb eines Außenleiter-Kontaktteils 3 mittig zentriert angeordnet.

Das Außenleiter-Kontaktteil 3 weist einen Befestigungsabschnitt 17 auf und einen Kontaktabschnitt 18. Im Bereich des Befestigungsabschnitts 17 ist der Außenleiter-Kontakt 3 auf dem Kabel 2 in einem vorfixierten Zustand festgelegt, wobei "vorfixiert" bedeutet, dass der Außenleiter-Kontakt 3 an dem Kabel 2 ortsfest und unverlierbar angeordnet ist, jedoch noch unter Aufbringen einer Kraft entfernt werden kann. Das Vorfixieren des Befestigungsabschnitts 17 an dem Kabel 2 ist durch ein Verpressen des Befestigungsabschnitts 17 mit mehreren, radial verstellbaren synchronisierten Pressstempeln durchgeführt worden. Im Bereich des Kontaktabschnitts 18 weist der Außenleiter-Kontakt 3 mehrere Kontakt-Zungen auf, die als federnd-elastische Freischnitte ausgebildet sind und die einen mechanischen sowie elektrischen Kontakt mit einem Außenleiter-Kontakt eines Gegensteckers herstellen.

Der in dem Isolator 4 aufgenommene Innenleiter-Kontakt 5 weist Innenleiter-Kontaktzungen auf, die einen mittigen Zwischenraum umgeben, derart, dass in den Zwischenraum ein stiftartiger Innenleiter-Kontakt eines Gegensteckers einführbar sein sollte, um einen mechanischen und elektrisch leitenden Kontakt auch zu dem Innenleiter-Kontakt des Gegensteckers herzustellen.

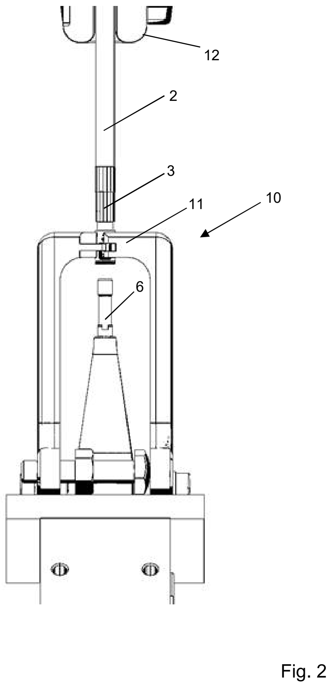

Die in Fig. 1 und 1a dargestellte Vorrichtung zur Erfassung des Rückstandsmaßes weist eine Messhülse 6, eine Halteeinheit 10 (Fig. 2), einen ersten Antrieb, der ausgebildet ist, die Messhülse 6 auf das Kabel 2 entlang einer Längsrichtung L zu bewegen, sowie eine Steuereinheit auf, die den ersten Antrieb und die Halteeinheit 10 ansteuert.

Die nur in Fig. 2 dargestellte, in den übrigen Darstellungen nicht dargestellte Halteeinheit 10 umfasst zwei Greiferbacken 11 einer Greifereinheit. Aus Fig. 2 ist ersichtlich, dass in einer Greif-Stellung die Greiferbacken 11 den Außenleiter-Kontakt 3 seitlich, im Bereich des Kontaktabschnitts 18, einspannen. Insbesondere ist aus Fig. 2 ersichtlich, dass der Kontaktabschnitt 18 zwischen ineinander greifenden Rippen der jeweiligen Greiferbacken **11** aufgenommen sind. Die Greiferbacken **11** der Greifereinheit können seitlich in die in Fig. 2 dargestellte Greif-Stellung geschwenkt oder radial in die Greif-Stellung verschoben werden. Die Steuereinheit steuert die Halteeinheit, nämlich die Greiferbacken **11** der Greifereinheit, so an, das Außenleiter-Kontaktteil 3 zentriert ausgerichtet zu einer Längsrichtung L ausgerichtet zu halten.

Die in Fig. 1, 1a dargestellte Vorrichtung zur Erfassung des Rückstandsmaßes umfasst die Messhülse 6, wobei die Messhülse 6 in einer Aufnahme 19 zwischen zwei Halteklammerpaaren unverlierbar aufgenommen ist, wobei die Aufnahme 19 weiter eine Platte 20 umfasst, auf der jedes der beiden Halteklammerpaare fest angeordnet ist, und wobei an der Platte 20 der Abgang eines Linearmotors des nicht weiter dargestellten ersten Antriebs angreift. Der Abgang des Linearmotors ist im Wesentlichen parallel zu der Längserstreckung der Messhülse 6 und parallel zu der Längsrichtung L gerichtet.

Die Steuereinheit ist ausgebildet, den ersten Antrieb, insbesondere den Linearmotor des ersten Antriebs so anzusteuern, dass die Messhülse 6 entlang der Längsrichtung L hin zu dem Kabel 2 bzw. von dem Kabel 2 fort bewegt werden kann.

Für die Messhülse 6 ist, wie aus Fig. 3 ersichtlich, vorgesehen, dass die Messhülse 6 ein Gehäuse 7, eine in dem Gehäuse 7 in der Längsrichtung L verschieblich geführte Messnadel 8 sowie einen Messtaster 9 (Fig. 1, 1a) umfasst.

Dabei erfasst der Messtaster 9 eine Verschiebung der Messnadel 8 in Bezug auf das Gehäuse 7, insbesondere dann, wenn in einer Messstellung die Messnadel 8 in den mittigen Zwischenraum zwischen den Innenleiter-Kontaktzungen des Innenleiter-Kontakts 5 eingeführt wird, also dann, wenn der erste Antrieb die Messhülse 6 in Längsrichtung L in Bezug auf das Kabel 2 so verschiebt, dass die Messnadel 8 in den Innenleiter-Kontakt 5 des Kabels 2 eindringt. Die Längsrichtung L ist dabei durch die Richtung definiert, entlang derer die Messnadel 8 in dem Gehäuse 7 verschieblich geführt ist.

Das Gehäuse 7 der Messhülse 6 weist an einem auf das Kabel 2 weisenden Ende einen Stützring 21 (Fig. 3) auf, wobei der Stützring 21 einen die Messnadel 8 umgebenden Rand aufweist, derart, dass der Rand eine gedachte Fläche begrenzt, die als Referenzfläche R der Messhülse 6 eine Bezugsebene für die Ermittlung des Rückstandsmaßes ausbildet. Die Messnadel 8 der Messhülse 6 ist mittels einer Feder vorgespannt in der Führung 22 des Gehäuses 7 aufgenommen, wobei die Federvorspannung so gewählt ist, dass die Spitze der Messnadel 8 in der durch den Rand des Stützrings 21 definierten Referenzfläche R liegt, so dass die Messnadel 8 eine definierte Ausgangsstellung aufweist.

Wird die Messhülse 6 in das Ende des teilkonfektionierten Kabels 2 eingeführt, also in eine Messstellung zur Ermittlung des Rückstandsmaßes verbracht, wird der Stützring 21 zwischen die Außenseite des Isolators 4 und die auf den Isolator 4 weisende Innenseite des Außenleiter-Kontaktteils 3 eingeführt.

Fig. 3 ist weiter zu entnehmen, dass das Gehäuse 7 der Messhülse 6 eine definierte Anlagefläche 15 aufweist, wobei die Anlagefläche 15 ausgebildet ist, an einer Gegen-Anlagefläche 16 des Isolators 4 anzuliegen, dann, wenn in der Messstellung die Messnadel 8 in den Innenleiter-Kontakt 4 eindringt. Die Anlagefläche 15 bildet zusammen mit der Gegen-Anlagefläche 16 eine Flächenpaarung aus, die das Einführen der Messhülse 6 in das Kabel 2 begrenzt. Die Anlagefläche 15 des Gehäuses 7 der Messhülse ist dabei als die Längsrichtung L umlaufende, bezogen auf die Längsrichtung L geneigte, Ringfläche ausgebildet. Entsprechend ist die Gegen-Anlagefläche 16 an einem Endabschnitt des Isolators 4 als die Einführöffnung in dem Isolator 4 umgebende Ringfläche ausgebildet, die bezogen auf die Längsrichtung L geneigt ist. Es ist weiter erkennbar, dass der Neigungswinkel der Anlagefläche 15 und der Gegen-Anlagefläche 16, jeweils bezogen auf die Längsrichtung L, im Wesentlichen den gleichen Betrag aufweist, in dem dargestellten Ausführungsbeispiel also ca. 45°. Wird das Gehäuse 7 der Messhülse 6 mit dem Isolator 4 in Anlage gebracht, wirken die gleichsinnig geneigten Anlagefläche 15 und die Gegen-Anlagefläche 16 in Richtung auf die Längsrichtung L hin zentrierend.

Die Vorrichtung 1 umfasst weiter eine Spanneinheit 12, die, wie aus Fig. 1a ersichtlich, das Kabel 2 in einem Abstand von dem Außenleiter-Kontakt 3 lösbar einspannt. Die dargestellte Spanneinheit 12 umfasst einen Leitungsspanner 23, zwischen dessen Spannbacken 24 eingespannt ein Abschnitt des Kabels 12 entlang der Längsrichtung L gerade ausgerichtet gehalten wird. Die Spannbacken 24 des Leitungsspanners 23 der Spanneinheit 12 fixieren das Kabel 2 sowohl in axialer Richtung, also in der Längsrichtung L, als auch quer zu der Längsrichtung L, so lange, bis die Spannbacken 24 gelöst werden. Der Leitungsspanner 23 weist hierzu einen pneumatischen oder hydraulischen Aktor 25 auf, dessen Betätigung die Spannbacken 24 lösen bzw. schließen.

Mittels des Leitungsspanners 23 wird das Kabel 2 in die Messstellung verfahren, also insbesondere in eine gerade gestreckte Ausrichtung entlang der Längsrichtung L, fluchtend mit der Richtung, entlang derer die Messnadel 8 der Messhülse 6 verschieblich in dem Gehäuse 7 geführt ist, gehalten, derart, dass das Kabel 2 während des Einführens der Messnadel 8 in den Innenleiter-Kontakt 5 zwischen der Spanneinheit 12, nämlich zwischen den Spannbacken 24 des Leitungsspanners 23, und den Greiferbacken 11 der Halteeinheit 10 gerade ausgerichtet entlang der Längsrichtung L gehalten ist. Dabei greifen die Spannbacken 24 des Leitungsspanners an dem Mantel des Kabels 2 an. Weiter greifen die Greiferbacken der Halteeinheit an dem Kontaktabschnitt 18 des Außenleiter-Kontakts 3 an.

Die Vorrichtung 1 umfasst weiter einen zweiten Antrieb für die Spanneinheit 12, insbesondere den Leitungsspanner 23, wobei der zweite Antrieb einen Motor 13 aufweist, und wobei der Motor 13 des zweiten Antriebs auf einer Längsführung 14 lösbar festlegbar und in eine Verschiebe-Richtung V längsverschieblich angeordnet ist, wie aus Fig. 1 ersichtlich. Die Verschiebe-Richtung V ist dabei räumlich parallel versetzt zu der Längsrichtung L ausgerichtet, entlang derer die Messnadel 8 in dem Gehäuse 7 der Messhülse 6 verschieblich geführt ist und entlang derer das Kabel 2 in der Spanneinheit 12 ausgerichtet gehalten ist. Der weitere Motor 13 ist dabei als Linearmotor ausgebildet mit einer sich längs und parallel zu der Längsrichtung L erstreckenden Abgangswelle 26 (Fig. 1).

Die Steuereinheit der Vorrichtung 1, die den ersten Antrieb und die Halteeinheit 10 ansteuert, weist, zusätzlich ausgebildet, den weiteren Vorteil auf, die Festlegung des Motors 13 an der Längsführung 14 zu lösen bzw. freizugeben.

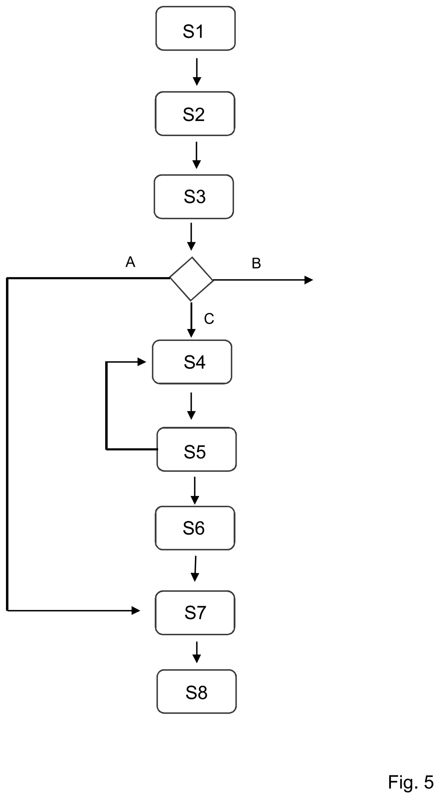

Im Folgenden wird die Funktion der Vorrichtung 1 zum Erfassen eines Rückstandsmaßes bei dem anhand von Fig. 3 erläuterten teilkonfektionierten Kabel 2 und der Messhülse 6, insbesondere auch eine bevorzugte Durchführung des Verfahrens zum Erfassen des Rückstandsmaßes bei dem teilkonfektionierten Kabel 2, mit Bezugnahme auf das Flussdiagramm von Fig. 5 sowie von Fig. 1 bis Fig. 4, näher beschrieben und erläutert.

Bei der Durchführung des ersten Verfahrensschritts S1 wird das teilkonfektionierte Kabel 2, in den Leitungsspanner 23 der Spanneinheit 12 eingespannt, in die Vorrichtung 1 eingeführt, wobei die Steuereinheit die Greiferbacken 11 der Halteeinheit 10 so ansteuert, dass die Greiferbacken den Außenleiter-Kontakt 3 des Kabels 2 im Bereich des Befestigungsabschnitts 17 seitlich einspannen. Das Kabel 2 wird dabei gerade gestreckt zwischen den Spannbacken 24 des Leitungsspanners 23, die den Kabelmantel des Kabels 2 abschnittsweise einklemmen, und den Greiferbacken 11 der Halteeinheit 10, die an dem Außenleiter-Kontakt 3 andrücken, gehalten. Dabei ist die Richtung, entlang derer das Kabel 2 gestreckt gehalten wird, in einer Flucht zu der Längsrichtung L, innerhalb derer die Messnadel 8 in der Messhülse 6 verschieblich ist, ausgerichtet. Der Außenleiter-Kontakt 3 ist dabei in einer vorfixierten, also ortsfesten und unverlierbaren, allerdings durch Kraftaufbringung noch entlang des Kabels 2 verschiebbaren, Anordnung an dem Mantel bzw. einem Schirmgeflecht des Kabels 2 angebracht.

Bei der Durchführung des zweiten Verfahrensschritts S2 wird die Messhülse 6 in die Vorrichtung 1 eingeführt. Hierzu steuert die Steuereinheit den ersten Antrieb so an, dass die Messhülse 6 in Richtung auf den Innenleiter-Kontakt 5 bewegt wird, und zwar derart, dass die Verschiebe-Richtung L der Messnadel 8 in dem Gehäuse 7 der Messhülse 6 in einer definierten Längsrichtung L ausgerichtet ist.

Bei der Durchführung des dritten Verfahrensschritts S3 steuert die Steuereinheit den ersten Antrieb so an, dass die Messhülse 6 auf das ausgerichtet gehaltene Kabel 2 so bewegt wird, dass die Anlagefläche 15 des Gehäuses 7 der Messhülse 6 in Anlage an die Gegen-Anlagefläche 16 an dem Ende des Isolators 4 des Kabels 2 gebracht wird. Das Anliegen der Flächen 15 und 16 aneinander kann beispielsweise dadurch erkannt werden, dass die Messnadel 8 nicht ohne weitere Kraftaufwendung verschiebbar ist. Aus der Verschiebung der Messnadel 8 relativ zu dem Gehäuse 7 der Messhülse 6 lässt sich das aktuelle Rückstandsmaß ermitteln.

Nach der Durchführung des Schrittes S3 kann das aktuelle, ermittelte Rückstandsmaß dem vorgegebenen Soll-Wert für das Rückstandsmaß, ggf. im Rahmen eines Toleranzbereichs, entsprechen (Option ,A' in der Darstellung von Fig. 5). Ist das der Fall, wird in einem folgenden Schritt S7 das Außenleiter-Kontaktteil 3 an dem Kabel 2 fest und endgültig fixiert, also aus der vorfixierten Anordnung (Schritt S1) in eine endgültig fixierte Anordnung überführt. Der Schritt S7 kann dabei so ausgeführt werden, dass, nachdem zuvor die Messhülse 6 aus dem Kabel 2 entfernt wurde, also nachdem die Messhülse 6 entgegen der Einführrichtung von dem Kabel 2 weg bewegt wurde, das Außenleiter-Kontaktteil 3 durch ein erneutes Verpressen des Befestigungsabschnitts 17 an dem Kabel 2 fest und nur noch unter Zerstörung der Anbindung mit dem Kabel 2, angeordnet wird. Das Verpressen kann dabei durch ein Rund-Verpressen, also durch die synchronisierte Betätigung radial gerichteter Pressbacken, erfolgen, dabei werden zugleich der Isolator 4 und der in dem Isolator 4 angeordnete Innenleiter-Kontakt 5, in Bezug auf den Außenleiter-Kontakt 3, räumlich fixiert und festgelegt. Insbesondere kann das Verpressen durch die gleiche Vorrichtung erfolgen, die zuvor die nur vorläufige Fixierung des Außenleiter-Kontakts 3 an dem Kabel 2 durchgeführt hat.

Nach der Durchführung des Schrittes S7 wird in einem Schritt S8 erneut das Rückstandsmaß des jetzt fest verpressten Innenleiter-Kontakts 5 in Bezug auf den Außenleiter-Kontakt 3 ermittelt. Hierzu steuert die Steuerung erneut die Messhülse 6 so an, dass die Messnadel 8 in den Innenleiter-Kontakt 5 des Kabels 2 erneut eindringt, um zu verifizieren, dass der vorgegebene Soll-Wert für das Rückstandsmaß durch das Verpressen bei Schritt S7 im Rahmen der vorgegebenen Toleranzen eingehalten wurde. Abschließend steuert die Steuereinheit den ersten Antrieb an, die Messhülse 6 endgültig von dem Kabel 2 fortzubewegen, sowie die Greiferbacken **11** der Halteeinheit 10, den Außenleiter-Kontakt 3 freizugeben, damit das Kabel 2 aus der Vorrichtung 1 heraus bewegt werden kann und die Konfektionierung des Kabels 2 fortgesetzt werden kann.

Nach der Durchführung des Schrittes S3 kann das aktuelle, ermittelte Rückstandsmaß von dem vorgegebenen Soll-Wert für das Rückstandsmaß abweichen und auch ggf. deutlich außerhalb eines vorgegebenen Toleranzbereichs für das Rückstandsmaß liegen. In diesem Fall muss das Kabel 2 verworfen und von der weiteren Bearbeitung ausgeschlossen werden (Option ,B' in der Darstellung von Fig. 5).

Nach der Durchführung des Schrittes S3 kann das aktuelle, ermittelte Rückstandsmaß von dem vorgegebenen Soll-Wert für das Rückstandsmaß abweichen und außerhalb eines vorgegebenen Toleranzbereichs für das Rückstandsmaß liegen. Allerdings kann die Abweichung so gering sein, dass eine Korrektur bzw. ein Nachjustieren, also ein nachträgliches Anpassen, des bei Schritt S3 ermittelten aktuellen Rückstandsmaßes möglich ist. In diesem Fall wird das Verfahren als Verfahren zur Einstellung eines Rückstandsmaßes mit den Verfahrensschritten S4 bis S6 fortgeführt, wobei die Vorrichtung 1 zusätzlich auch als Vorrichtung 1 zur Einstellung eines Rückstandsmaßes ausgebildet ist (Option ,C' in der Darstellung von Fig. 5).

Dabei ist die Vorrichtung 1 zur Einstellung des Rückstandsmaßes so ausgebildet, den ersten Antrieb so lange anzusteuern, bis das erfasste Rückstandsmaß dem vorgegebenen Soll-Wert für das Rückstandsmaß, im Rahmen eines Toleranzbereichs, entspricht.

Ist insbesondere das aktuelle, nach dem Schritt S3 ermittelte, Rückstandsmaß geringer als der Soll-Wert für das Rückstandsmaß und die Differenz zwischen dem aktuellen Rückstandsmaß und dem Soll-Wert für das Rückstandsmaß nicht zu groß, wird bei der Durchführung des Schrittes S4 die Anlagefläche 15 der Messhülse 6 an die Gegen-Anlagefläche 16 des Isolators 4 mit einer definierten Andrückkraft geführt, beispielsweise mittels einem definierten Vorschub in Millimeter pro Sekunde, und das jeweils aktuelle Rückstandsmaß erneut, insbesondere regelmäßig bzw. kontinuierlich, ermittelt. Das Andrücken der Anlagefläche 15 an die Gegen-Anlagefläche 16 erfolgt derart, dass die Steuereinheit den ersten Antrieb so ansteuert, dass die Messhülse 6 mit einer definierten Kraft gegen den Isolator 4 drückt. Dabei bleibt das Kabel 2 im Bereich des Außenleiter-Kontakts 3 ortsfest gehalten und in der Spanneinheit 12, also dem Leitungsspanner 23, fest eingespannt. Dabei verschiebt sich der Isolator 4 zusammen mit dem in dem Isolator 4 aufgenommenen Innenleiter-Kontakt 3 relativ zu dem ortsfest gehaltenen, an dem Kabel 2 nur vorfixiert befestigten Außenleiter-Kontakt 5, so dass das Rückstandsmaß vergrößert wird.

Gemäß dem Verfahrensschritt S5 wird der Verfahrensschritt S4 so lange durchgeführt, bis das aktuelle Rückstandsmaß dem vorgegebenen Soll-Wert für das Rückstandsmaß, innerhalb des Toleranzbereichs, entspricht. Ist das erreicht, verbleiben die Anlagefläche 15 und die Gegen-Anlagefläche 16 erst einmal in Kontakt, allerdings steuert die Steuereinheit den ersten Antrieb an, keine weitere Andrückkraft, insbesondere keinen weiteren Vorschub, auf das Kabel 2 auszuüben.

Bei der Durchführung des Verfahrensschritts S4 treten Materialspannungen, insbesondere innere Druckkräfte entlang der Erstreckung des Kabels 2 zwischen der Halteeinheit 10 und der Spanneinheit 12 auf. Diese Materialspannungen können dazu führen, dass das bei Schritt S1 gestreckt gehalten eingeführte Kabel 2 seitlich ausbricht und sollten daher abgebaut bzw. reduziert werden.

Der Verfahrensschritt S6 "Beseitigen von Materialspannungen in dem Kabel 2" wird dabei derart durchgeführt, dass die Steuereinheit die Festlegung des Motors 13 des zweiten Antriebs auf der Längsführung 14 für eine kurze Zeitspanne löst, damit der Motor 13 entlang der Verschiebe-Richtung V ausweichen kann. Während des Ausweichens bleibt der Leitungsspanner 23 der Spanneinheit 12 geschlossen, so dass das Abbauen der Materialspannungen in dem Kabel 2 ausschließlich in die Verschiebe-Richtung V, also parallel versetzt zu der Längsrichtung L, entlang derer die Materialspannungen in das Kabel 2 eingebracht wurden, erfolgen kann. Insbesondere ist die Längsführung 14 parallel versetzt zu der Längsrichtung L ausgerichtet angeordnet.

Nach dem Beseitigen der Materialspannungen in dem Kabel 2 (Schritt S6) erfolgt dann die weitere Bearbeitung des Kabels 2 anhand der Schritte S7 und S8, wie oben, für die Option "A" aus Fig. 5, beschrieben.

### BEZUGSZEICHENLISTE

- 1: Vorrichtung
- 2: teil konfektioniertes Kabel
- 3: Außenleiter-Kontakt
- 4: Isolator
- 5: Innenleiter-Kontakt
- 6: Messhülse
- 7: Gehäuse der Messhülse 6
- 8: Messnadel
- 9: Messtaster
- 10: Halteeinheit
- 11: Greiferbacken
- 12: Spanneinheit
- 13: Motor
- 14: Längsführung
- 15: Anlagefläche des Gehäuses 7 der Messhülse 6
- 16: Gegen-Anlagefläche an dem Ende des Isolators 4 des Kabels 2
- 17: Befestigungsabschnitt des Außenleiter-Kontakts 3
- 18: Kontaktabschnitt des Außenleiter-Kontakts 3
- 19: Aufnahme für die Messhülse 6
- 20: Platte
- 21: Stützring
- 22: Führung für die Messnadel 8 in dem Gehäuse 7
- 23: Leitungsspanner
- 24: Spannbacke des Leitungsspanners 23
- 25: Aktor des Leitungsspanners 23
- 26: Abgangswelle des weiteren Motors 13

- L: Längsrichtung
- R: Referenzebene
- V: Verschiebe-Richtung

## Patentansprüche

1. Vorrichtung (1) zum Erfassen des Rückstandsmaßes bei einem teilkonfektionierten Kabel (2), wobei das teilkonfektionierte Kabel (2) einen Außenleiter-Kontakt (3), einen innerhalb des Außenleiter-Kontakts (3) aufgenommenen, innerhalb eines Isolators (4) angeordneten Innenleiter-Kontakt (5) aufweist ist, wobei die Vorrichtung (1) umfasst:
eine Messhülse (6) mit einem Gehäuse (7), einer in dem Gehäuse (7) in einer Längsrichtung (L) verschieblich geführten Messnadel (8) und einem Messtaster (9), wobei der Messtaster (9) die Verschiebung der Messnadel (8) in Bezug auf das Gehäuse (7) erfasst, und wobei das Gehäuse (7) eine Referenzebene (R) aufweist,
eine Halteeinheit (10), die ausgebildet ist, den Außenleiter-Kontakt (3) des teilkonfektionierten Kabels (2) ortsfest zu halten,
einen ersten Antrieb, der ausgebildet ist, die Messhülse (6) in der Längsrichtung (L) in Bezug auf das Kabel (2) so zu verschieben, dass die Messnadel (8) in den Innenleiter-Kontakt (5) des Kabels (2) eindringt,
wobei die Halteeinheit (10) ausgebildet ist, das Außenleiter-Kontaktteil (3) zentriert zu der Längsrichtung (L) ausgerichtet zu halten, und
eine Steuereinheit, die den ersten Antrieb und die Halteeinheit (10) ansteuert.

2. Vorrichtung nach Anspruch 1, wobei die Vorrichtung (1) zur Einstellung eines Rückstandsmaßes ausgebildet ist, wobei die Steuereinheit ausgebildet ist, den ersten Antrieb so lange anzusteuern, bis das erfasste Rückstandsmaß einem vorgegebenen Soll-Wert entspricht.

3. Vorrichtung nach Anspruch 1 oder 2, wobei die Halteeinheit (10) zwei Greiferbacken (11) einer Greifereinheit umfasst, und wobei die Greiferbacken (11) den Außenleiter-Kontakt (3) seitlich einspannen.

4. Vorrichtung nach einem der Ansprüche 1 bis 3, weiter umfassend eine Spanneinheit (12), die das Kabel (2) in einem Abstand von dem Außenleiter-Kontakt (3) lösbar einspannt, wobei die Spanneinheit (12) insbesondere einen Leitungsspanner (23) aufweist.

5. Vorrichtung nach Anspruch 4, weiter umfassend einen zweiten Antrieb für die Spanneinheit (12), wobei der zweite Antrieb einen Motor (13) aufweist, wobei der Motor (13) auf einer Längsführung (14) lösbar festlegbar und längsverschieblich in eine Verschiebe-Richtung (V) angeordnet ist, und wobei die Verschiebe-Richtung (V) parallel versetzt zu der Längsrichtung (L) ausgerichtet ist.

6. Vorrichtung nach einem der Ansprüche 1 bis 5, wobei das Gehäuse (7) der Messhülse (6) eine Anlagefläche (15) aufweist, die ausgebildet ist, an einer Gegen-Anlagefläche (16) des Isolators (4) anzuliegen, wenn die Messnadel (8) in den Innenleiter-Kontakt (5) eindringt.

7. Vorrichtung nach Anspruch 6, wobei der Neigungswinkel der Anlagefläche (15) und der Gegen-Anlagefläche (16), jeweils bezogen auf die Längsrichtung (L), im Wesentlichen gleich ist.

8. Verfahren zum Erfassen, insbesondere zum Einstellen eines Rückstandsmaßes bei einem teilkonfektionierten Kabel, mit den Schritten:
S1: Bereitstellen des teilkonfektionierten Kabels (2), wobei das teilkonfektionierte Kabel (2) einen Außenleiter-Kontakt (3), einen innerhalb des Außenleiter-Kontakts (3) aufgenommenen, innerhalb eines Isolators (4) angeordneten, Innenleiter-Kontakt (5) aufweist,
S2: Bereitstellen einer Messhülse (6) mit einem Gehäuse (7) mit einer in dem Gehäuse (7) längsverschieblich geführten Messnadel (8) und mit einem Messtaster (9), wobei der Messtaster (9) die Verschiebung der Messnadel (8) in Bezug auf das Gehäuse (7) erfasst, und wobei das Gehäuse (7) eine Referenzebene (R) aufweist, derart, dass die Verschiebe-Richtung (L) der Messnadel (8) in Längsrichtung (L) liegt,
S3: In-Anlage-Bringen einer Anlagefläche (15) des Gehäuses (7) der Messhülse (6) an eine Gegen-Anlagefläche (16) an dem Isolator (4) des Kabels (2), und Erfassen einer Verschiebung der Messnadel (8) relativ zu dem Gehäuse (7) durch den Messtaster (9) der Messhülse (6) und Ermitteln des Rückstandsmaßes,
S4: Andrücken der Anlagefläche (15) der Messhülse (6) an die Gegen-Anlagefläche (16) des Isolators (4), wenn das in Schritt S3 ermittelte Rückstandsmaß geringer ist als ein vorgegebener Sollwert und Erfassen des Rückstandsmaßes,
S5: Durchführen des Schrittes S4 so lange, bis das ermittelte Rückstandsmaß dem vorgegebenen Soll-Wert entspricht, und
S6: Beseitigen von Materialspannungen in dem Kabel (2).

9. Verfahren nach Anspruch 8, weiter umfassend den Schritt S7: Fixieren des Außenleiter-Kontakts (3) derart, dass der Außenleiter-Kontakt (3) fest an dem Kabel (2) angeordnet ist, auszuführen nach Schritt S3 oder nach Schritt S6.

10. Verfahren nach Anspruch 9, umfassend den Schritt:
S8: Abschließendes Erfassen des Rückstandsmaßes, auszuführen nach Schritt S7.
